(19) **Europäisches Patentamt / European Patent Office / Office européen des brevets**

(11) **EP 3 822 670 A1**

(12) # DEMANDE DE BREVET EUROPEEN

(43) Date de publication:
**19.05.2021 Bulletin 2021/20**

(21) Numéro de dépôt: **20208331.7**

(22) Date de dépôt: **18.11.2020**

(51) Int Cl.:
**G02B 5/18** (2006.01) **G03F 7/00** (2006.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
**KH MA MD TN**

(30) Priorité: **18.11.2019 FR 1912857**

(71) Demandeur: **Commissariat à l'Energie Atomique et aux Energies Alternatives 75015 Paris (FR)**

(72) Inventeurs:
- **LANDIS, Stefan**
  **38054 GRENOBLE CEDEX 9 (FR)**
- **TEYSSEDRE, Hubert**
  **38054 GRENOBLE CEDEX 9 (FR)**

(74) Mandataire: **Hautier, Nicolas Cabinet Hautier 20, rue de la Liberté 06000 Nice (FR)**

(54) **PROCÉDÉ DE FABRICATION D'UN DISPOSITIF MICROÉLECTRONIQUE PRÉSENTANT UN RÉSEAU DE RELIEFS INCLINÉS**

(57)    L'invention porte notamment sur un procédé de réalisation d'un dispositif (30, 30') microélectronique, par exemple un moule pour nanoimpression, présentant un réseau ultérieur (33, 33') de reliefs (310, 310') dont au moins une paroi (313, 314, 313', 314') est inclinée, le procédé comprenant au moins les étapes suivantes:
- fournir une structure comprenant:
◦ une base (31, 31'),
◦ un réseau initial (32, 32') de reliefs (310, 310'), chaque relief (310, 310') présentant au moins une extrémité proximale (311, 311') au contact de la base (31, 31'), une extrémité distale (312, 312') et au moins une paroi (313, 314, 313', 314') s'étendant entre l'extrémité proximale (311, 311') et l'extrémité distale (312, 312'),

- coucher les reliefs (310, 310') du réseau initial (32, 32') les uns sur les autres, par application d'au moins une contrainte sur la structure, de sorte que des parois (313, 314, 313', 314') en regard de deux reliefs (310, 310') adjacents entrent au contact, générant ainsi au moins un réseau ultérieur (33, 33') de reliefs (310, 310') dont au moins une paroi (313, 314, 313', 314') est inclinée.

FIG. 11B

EP 3 822 670 A1

## Description

### DOMAINE TECHNIQUE

L'invention concerne le domaine de la réalisation de réseaux de motifs ou structures présentant chacun au moins un flanc incliné. Ces réseaux sont généralement appelés réseaux blazés par référence au vocable anglais « blazed gratings ».

L'invention trouve par exemple pour application avantageuse les réseaux de diffraction appliqués notamment aux domaines de l'affichage ou de l'optronique.

### ETAT DE LA TECHNIQUE

Pour de nombreuses applications, par exemple dans les domaines de l'affichage ou de l'optronique, il est avantageux de réaliser des structures dont au moins un flanc est incliné, c'est-à-dire qu'il n'est ni parallèle, ni perpendiculaire, à un plan dans lequel s'étend principalement le substrat portant les motifs.

Les solutions connues pour réaliser des réseaux de motifs présentant au moins un flanc incliné font intervenir des étapes de lithographie par faisceau d'électrons (habituellement désigné par l'acronyme EBL du vocable anglais « electron beam lithography») à modulation de dose.

L'EBL est connu pour permettre la réalisation de structures de type escalier à plusieurs marches en modulant la dose déposée localement dans la résine positive.

Afin d'obtenir des structures présentant un flanc incliné et sans marche d'escalier, les deux approches ci-dessous sont possibles.

Une première approche consiste à augmenter le nombre de marches pour une hauteur donnée d'escalier. Chacune des marches présente alors une hauteur plus faible et le profil général de la structure se rapproche d'un flanc incliné. Cette première approche présente pour inconvénient de ne pas supprimer la présence de marches. Elle présente surtout comme inconvénient un temps de réalisation et donc un coût particulièrement élevés.

Une deuxième approche consiste à faire fluer la résine, c'est-à-dire à imposer un recuit de la résine au-dessus de sa température de transition vitreuse, afin de lisser le profil en marches d'escalier. Cette approche a été proposée dans l'article « Fabrication of 3D patterns with vertical and sloped sidewalls by grayscale electron-beam lithography and thermal annealing » publié par Arne Schleunitz, Helmut Schift dans la revue Microelectronic Engineering, 88 (2011) 2736-2739.

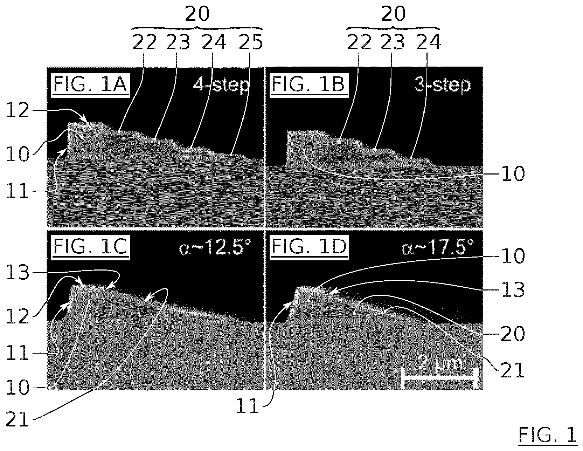

Les figures 1A à 1D sont tirées de cet article. Les figures 1A et 1B sont des photos prises par microscope électronique à balayage (SEM) d'une structure multiniveaux en forme d'escalier présentant respectivement quatre marches 22-25 et trois marches 22-24.

La structure en forme d'escalier comporte une portion 10 formant le haut de l'escalier et une portion 20 formant les marches 22-25. La portion 10 présente un sommet 12 et un flanc 11 perpendiculaire au substrat. La portion 10 n'a pas reçu de dose. La portion 20 est formée dans une partie de la résine positive ayant reçu une dose trop faible pour être complètement développée.

Les figures 1C et 1D illustrent les résultats obtenus après fluage des structures des figures 1A et 1B respectivement. Chacune de ces structures comprend un flanc 21 présentant un profil incliné sensiblement continu, obtenu par fluage de la portion 20.

Il s'avère en pratique que ce type de solution n'est pas compatible avec des débits de production et de grandes surfaces d'exposition. Cela limite donc son utilisation à l'échelle industrielle avec des coûts raisonnables.

En outre, il arrive souvent que les paramètres du fluage ne permettent pas d'obtenir un flanc 21 réellement continu, c'est-à-dire ne présentant pas de discontinuité correspondant à des résidus de marches.

Par ailleurs, on constate un décroché 13 ou une marche entre le sommet 12 de la portion 10.

Il existe donc un besoin consistant à proposer une solution pour atténuer, voire pour supprimer, au moins l'un des inconvénients des solutions de l'état de la technique.

Tel est un objectif de la présente invention.

En particulier, un objectif de la présente invention consiste à proposer une solution pour obtenir un réseau de structures présentant chacune au moins un flanc incliné avec une productivité améliorée par rapport aux solutions connues.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un premier aspect la présente invention prévoit un procédé de réalisation d'un dispositif microélectronique présentant un réseau ultérieur de reliefs dont au moins une paroi est inclinée. Le procédé comprenant au moins les étapes suivantes :

- fournir une structure comprenant:

    ◦ une base,
    ◦ un réseau initial de reliefs, chaque relief présentant au moins une extrémité proximale au contact de la base, une extrémité distale et au moins une paroi s'étendant entre l'extrémité proximale et l'extrémité distale,

- coucher les reliefs du réseau initial les uns sur les autres, par application d'au moins une contrainte sur la structure, de sorte que des parois en regard de deux reliefs adjacents entrent au contact. Par exemple, on considère que le réseau initial comprend au moins deux reliefs adjacents de sorte que des parois en regard desdits au moins deux reliefs adjacents entrent en contact. On obtient ainsi au moins un réseau ultérieur de reliefs présentant chacun au moins une paroi inclinée.

Ainsi, ce procédé propose de provoquer un effondrement contrôlé des reliefs réalisés sur une structure déformable. Les reliefs du réseau initial s'inclinent par rapport à la base pour se coucher les uns sur les autres. Cette inclinaison est rémanente et subsiste après application et/ou retrait de la contrainte. Les reliefs présentent alors chacun au moins une portion de paroi accessible depuis l'extérieur du dispositif et qui est inclinée par rapport à un plan dans lequel s'étend principalement la base. Ainsi, l'invention tire avantageusement profit du phénomène d'effondrement de motifs pour former un dispositif présentant un réseau de motifs inclinés. Dans le domaine de la micro-électronique, on cherche à éviter ce phénomène d'effondrement des motifs qui est habituellement perçu comme une contrainte préjudiciable, puisque responsable des défauts sur les structures que l'on souhaite obtenir.

On obtient ainsi une structure comprenant des motifs dont les flancs sont inclinés par rapport à une normale au plan dans lequel s'étend principalement la structure. Par ailleurs, l'angle définissant cette inclinaison est contrôlé avec précision. En outre, ce procédé permet de former aisément un réseau dont les reliefs sont dissymétriques, i.e., les parois adjacentes d'un même relief, par exemple les parois définissant le sommet d'un relief, présentent des inclinaisons différentes par rapport à la normale au plan dans lequel s'étend principalement la structure.

Selon un exemple non limitatif, le dispositif forme un moule pour impression nanométrique. Le moule est destiné à transférer, par impression nanométrique, l'inverse des reliefs inclinés dans une couche déformable.

Selon un autre mode de réalisation, le dispositif ne forme pas un moule pour nanoimpression. Il peut par exemple former un dispositif optique ou un empilement destiné à être ensuite transféré dans un substrat sous-jacent par gravure.

De préférence, les reliefs de la structure ont été formés, avant couchage, par l'une des techniques suivantes de lithographie : lithographie optique, lithographie électronique, impression nanométrique.

Un autre aspect de la présente invention concerne un procédé de réalisation d'au moins un réseau de motifs inclinés sur une couche, le procédé comprenant au moins les étapes suivantes :

- fournir un moule pour impression nanométrique en mettant en œuvre le procédé décrit ci-dessus ;
- faire pénétrer le réseau ultérieur de reliefs inclinés dans la couche pour former sur une première face de la couche un réseau de motifs fonction des reliefs inclinés,
- détacher le moule de la couche

Ainsi, on peut réaliser par nanoimpression d'une couche de résine, un réseau de motifs présentant chacun une face inclinée. Ce réseau de motifs est obtenu de manière particulièrement simple et reproductible à partir d'un moule présentant des reliefs inclinés par effondrement d'un réseau initial de reliefs.

Les motifs inclinés du réseau peuvent présenter une paroi inclinée parfaitement lisse. En effet, cette paroi est formée par inclinaison d'une paroi initialement verticale que l'on peut obtenir aisément avec les procédés classiques de lithographie (lithographie optique, lithographie électronique, impression nanométrique).

En ce sens, la présente invention permet d'éviter les inconvénients des solutions connues mentionnées dans la section relative à l'état de la technique et qui prévoient la formation d'un profil en marches d'escalier pour obtenir une paroi inclinée.

En outre, la solution proposée permet d'obtenir une paroi inclinée, lisse, adjacente à une paroi d'extrémité qui lui est perpendiculaire.

Le sommet de chaque motif est défini par des parois présentant des inclinaisons dissymétriques par rapport à la normale au plan dans lequel s'étend principalement la deuxième face de la couche.

En outre, contrairement à la solution de l'état de la technique mentionné ci-dessus, la solution proposée présente pour avantage de ne pas nécessiter l'utilisation de résines compatibles avec une lithographie à niveaux de gris.

Par ailleurs, contrairement à l'état de la technique mentionné ci-dessus, la solution proposée permet aisément d'éviter l'apparition d'un décroché ou d'une marche entre une première portion de structure formant un flanc présentant une première inclinaison et une deuxième portion de structure formant un flanc présentant une deuxième inclinaison. Ce décroché 13 est visible en figures 1C et 1D.

La solution proposée permet de réduire considérablement le nombre d'étapes et donc la durée d'exécution par comparaison à la solution de l'état de la technique présentée ci-dessus et nécessitant une structure de départ multiniveaux.

La solution proposée permet donc d'augmenter considérablement les débits de production.

Par ailleurs, la solution proposée est parfaitement compatible avec de grandes surfaces. En effet, cette solution permet en une seule étape d'impression de former de très nombreux motifs à la surface d'un substrat et ne nécessite pas l'utilisation d'une lithographie localisée telle qu'une lithographie par faisceau d'électrons comme le prévoit l'état de la technique mentionné ci-dessus.

De manière facultative, le procédé de réalisation d'un dispositif microélectronique présentant un réseau de reliefs inclinés peut en outre présenter au moins l'une quelconque des caractéristiques suivantes qui peuvent être prises séparément ou en combinaison:

- des paramètres du réseau initial, comprenant notamment une forme des reliefs, un pas P du réseau initial et un matériau du réseau initial, sont choisis de sorte à ce qu'après couchage des reliefs, chaque relief présente au moins une paroi inclinée d'un angle $\alpha$ différent de 90° par rapport à un plan z1x1 dans lequel s'étend principalement une face de la base.
- après couchage, il n'y a pas de vide ou de cavités fermées entre deux reliefs adjacents.
- les reliefs du réseau initial forment, avant l'étape de couchage, au moins l'un parmi :

  ∘ des lignes s'étendant principalement selon une direction z1 parallèle à un plan z1x1 dans lequel est principalement compris une face de la base de la structure depuis laquelle s'étendent les reliefs et
  ∘ des plots de section polygonale ou circulaire, la section étant prise selon le plan z1x1.

- avant l'étape de couchage des reliefs, l'au moins une paroi s'étend principalement selon une direction y1 perpendiculaire ou une direction z1 parallèle à un plan z1x1 dans lequel est principalement comprise une face de la base de la structure depuis laquelle s'étendent les reliefs.
- selon un exemple l'au moins une contrainte comprend ou est une force. Cette force est prise parmi: une force de contact et une force sans contact.
- selon un mode de réalisation, coucher les reliefs comprend l'application d'au moins une contrainte sur au moins l'un parmi la base de la structure et les reliefs, de préférence au moins l'extrémité des reliefs, et l'application d'une contrainte complémentaire ou d'une force de réaction (R) sur l'autre parmi la base de la structure et les reliefs, de préférence au moins l'extrémité des reliefs, et de sorte à provoquer un déplacement relatif entre la base de la structure et les reliefs. Ainsi, selon cet exemple, la déformation ou l'effondrement des reliefs est obtenu par application de contraintes. Ce mode de réalisation est particulièrement simple à mettre en œuvre.
- selon un mode de réalisation, coucher les reliefs comprend l'application d'au moins une force (F1, F2) de contact sur au moins l'un parmi la base de la structure et les reliefs, de préférence au moins l'extrémité des reliefs, et l'application d'une force complémentaire ou d'une force de réaction (R) sur l'autre parmi la base de la structure et les reliefs, de préférence au moins l'extrémité des reliefs, et de sorte à provoquer un déplacement relatif entre la base de la structure et les reliefs. Ainsi, selon cet exemple, la déformation ou l'effondrement des reliefs est obtenu par application de forces de contact. Ce mode de réalisation est particulièrement simple à mettre en œuvre.
- l'au moins une force (F1, F2) de contact de la structure présente :

  ∘ une composante (F1) sensiblement parallèle à un plan z1x1 dans lequel est principalement comprise une face de la base du moule depuis laquelle s'étendent les reliefs;
  ∘ une composante (F2) sensiblement perpendiculaire au plan. z1x1.

Généralement, la composante F2 est appliquée parallèlement à la direction principale selon laquelle les reliefs s'étendent dans le plan x1y1.

Selon un exemple, l'au moins une force (F1, F2) de contact est appliquée sur la base de la structure lorsque les extrémités distales des reliefs de la structure sont au contact d'un substrat intermédiaire.

Ainsi, selon ce mode de réalisation, afin de faire s'effondrer les reliefs de la structure, on peut appliquer un effort tendant à déplacer la base de la structure sans déplacer les extrémités distales des reliefs qui restent ancrées dans le substrat intermédiaire. La force de contact est ainsi appliquée sur la base du moule. Le substrat intermédiaire applique une force de réaction sur les reliefs, plus précisément sur leurs extrémités distales.

- Selon un autre mode de réalisation, coucher les reliefs comprend l'application d'un jet de fluide sur les reliefs du réseau initial. Le jet peut être un jet de liquide ou de gaz. Il peut être projeté sous forme d'un faisceau ou d'une nappe. Dans ce cas, la contrainte exercée par les reliefs est une force sans contact.
- Selon un premier exemple non limitatif, fournir la structure comprend une étape de nanoimpression pour réaliser le réseau initial de reliefs. Alternativement, fournir la structure comprend une étape de lithographie optique ou électronique, pour réaliser le réseau initial.

**BREVE DESCRIPTION DES FIGURES**

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

Les figures 1A et 1B sont des photos par microscope électronique à balayage (SEM) de structures multiniveaux selon l'état de la technique, c'est à dire des structures présentant une forme d'escalier. Les figures 1C et 1D illustrent les résultats obtenus après fluage des structures des figures 1A et 1B respectivement.

La figure 2A illustre une première étape de réalisation d'un dispositif micro-électronique destiné à former un moule pour impression nanométrique. Cette figure illustre le moule avant effondrement des reliefs.

La figure 2B illustre le résultat d'une deuxième étape de réalisation du moule illustré en figure 2A. Cette figure illustre le moule après effondrement des reliefs.

La figure 3A illustre un empilement comprenant une couche de résine.

La figure 3B illustre le résultat d'une étape d'impression dans la résine du moule obtenu en figure 2B.

La figure 3C représente une vue agrandie de la zone A illustrée en figure 2D.

Les figures 4A à 4D illustrent de manière schématique des étapes d'un premier mode de réalisation d'une structure présentant un réseau de reliefs, avant inclinaison des reliefs.

Les figures 5A à 5D illustrent de manière schématique des étapes d'un deuxième mode de réalisation d'une structure présentant un réseau de reliefs, avant inclinaison des reliefs.

Les figures 6A à 6D illustrent de manière schématique des étapes d'un troisième mode de réalisation d'une structure présentant un réseau de reliefs, avant inclinaison des reliefs.

La figure 7 illustre un exemple de moule avant inclinaison des reliefs.

Les figures 8A à 8B illustrent de manière schématique des étapes d'un mode de réalisation d'un moule. La figure 8A illustre un moule obtenu après inclinaison des reliefs du moule illustré en figure 7. La figure 8B représente un agrandissement de la zone B illustrée en figure 8A.

La figure 9 est un graphe illustrant le domaine d'angles accessibles pour les réseaux blazés en fonction de la géométrie du réseau initial.

La figure 10 est un graphe illustrant le domaine d'angles accessibles pour les réseaux blazés en fonction de la géométrie du réseau initial.

Les figures 11A à 11F illustrent de manière schématique des étapes d'un premier mode de réalisation d'un réseau blazé.

Les figures 12A à 12E illustrent de manière schématique des étapes d'un deuxième mode de réalisation d'un réseau blazé.

Les figures 13A et 13B sont des images au microscope électronique d'un master, présentant un réseau de lignes et destiné à réaliser un moule. L'image de la figure 13B est un agrandissement de l'image de la figure 13A.

Les figures 14A et 14B sont des images au microscope électronique d'une résine dans laquelle des motifs inclinés ont été transférés par nanoimpression.

La figure 15A est une image au microscope électronique d'un master, présentant un réseau de lignes et destiné à réaliser un moule.

Les figures 15B à 15G illustrent de manière schématique des étapes d'un mode de réalisation d'un moule présentant un réseau blazé, ce moule est obtenu en partant d'un master dont est tirée la photo de la figure 15A. Ces figures illustrent également la réalisation, par nanoimpression à partir du moule, d'un réseau de motifs inclinés dans une couche de résine puis son transfert dans un substrat.

La figure 16 comprend plusieurs images réalisées au microscope électronique et montrant quatre types de réseaux de reliefs réalisés dans des masters (ligne L1 de figures). La ligne L2 d'images sont les images vue du dessus de réseaux de motifs obtenus dans une résine par impression de moules fabriqués à partir de masters de la ligne L1.

La ligne L3 d'images correspond aux vues en coupe des réseaux de motifs illustrés sur les images de la ligne L2.

La figure 17 est un graphe illustrant le décalage constant qui peut apparaitre entre l'angle attendu avec les géométries imposées aux masters et l'angle effectivement mesuré dans le réseau formé par le moule.

Les figures 18A et 18B illustrent de manière schématique des étapes d'un exemple de fabrication d'un dispositif micro-électronique, comprenant par exemple un substrat surmonté d'une couche de résine, et dans lequel un réseau de reliefs inclinés est réalisé dans la résine.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et des différents motifs ne sont pas nécessairement représentatifs de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :

- Selon un exemple, les motifs du moule présentent chacun au moins un flanc incliné d'un angle $\alpha$ différent de 90° par rapport à un plan $z_2x_2$ dans lequel s'étend principalement une deuxième face de la couche opposée à la première face.
- Selon un exemple, coucher les reliefs de la structure initiale du moule comprend l'application d'au moins une force (F1, F2) de contact sur au moins l'un parmi la base de la structure et les reliefs, de préférence au moins l'extrémité des reliefs, et l'application d'une force complémentaire ou d'une force de réaction sur l'autre parmi la base de la structure et les reliefs, de préférence au moins l'extrémité des reliefs, et de sorte à provoquer un déplacement relatif entre la base de la structure et les reliefs.
- Selon un exemple, l'au moins une force (F1, F2) de contact de la structure présente :

  ○ une composante (F1) sensiblement parallèle à un plan $z_1x_1$ dans lequel est principalement comprise une face de la base depuis laquelle s'étendent les reliefs ;
  ○ une composante (F2) sensiblement perpendiculaire au plan $z_1x_1$.

- Selon un exemple, l'au moins une force (F1, F2) de contact est appliquée sur la base de la structure lorsque les extrémités distales des reliefs de la structure sont au contact d'un substrat intermédiaire le substrat présentant une face destinée à entrer au contact des extrémités distales des reliefs, ladite face comprenant de préférence un film présentant un coefficient de friction inférieur ou égal à 0,01.

Ce mode de réalisation permet de contrôler avec précision l'effondrement des motifs.

- Selon un exemple, l'au moins une force de contact est appliquée sur la base du moule avant mise en contact du moule et de la couche et lorsque les extrémités distales des reliefs du moule sont au contact d'un substrat intermédiaire.
- Selon un exemple, l'au moins une force (F1, F2) de contact est appliquée sur la base du moule après pénétration d'une partie au moins du réseau initial de reliefs dans la couche, de préférence avant une pénétration complète des reliefs du moule dans la couche.
- Ce mode de réalisation permet de limiter le nombre d'étapes. Il apporte ainsi une solution efficace face à la problématique consistant à réduire la durée et le coût du procédé.
- Selon un exemple, les reliefs présentent, avant couchage, une hauteur H prise entre l'extrémité distale des reliefs et une face de la base du moule depuis laquelle s'étendent les reliefs. L'au moins une force (F1, F2) de contact est appliquée sur la base du moule lorsque la hauteur hp des reliefs ayant pénétrée dans la couche est comprise entre 0.1 et 0.7 fois la hauteur H des reliefs. On s'assure ainsi d'un bon ancrage les extrémités distales des reliefs à l'intérieur de la couche. Cela favorise le contrôle de l'inclinaison des reliefs et donc la géométrie finale obtenue.
- Selon un exemple, coucher les reliefs du réseau initial du moule comprend d'appliquer un jet de fluide sur les reliefs du moule. Ainsi, dans cet exemple la contrainte appliquée aux reliefs est un jet de fluide.
- Ce mode de réalisation permet de réduire les défauts qui peuvent apparaître dans les modes de réalisations qui prévoient le couchage des reliefs par application d'une force de contact. En effet, dans ces modes de réalisation, un défaut de contact, tels que la présence d'une poussière à l'interface entre les reliefs et le point d'application de la force peut entraîner un défaut dans le positionnement des reliefs.
- Selon un exemple, les reliefs du moule présentent un matériau de base et un revêtement recouvrant le matériau de base, le revêtement présentant un coefficient de friction inférieure à celui du matériau de base.

Ainsi, le moule, tout au moins les reliefs du moule, son recouvert d'un traitement antiadhésif. Cela permet de faciliter le détachement du moule après impression dans la couche déformable. On évite ainsi que des résidus de la couche déformable subsistent entre les reliefs du moule. La qualité du réseau de motifs formés est ainsi améliorée.

- Selon un exemple, après avoir détaché le moule de la couche, une étape de transfert est comprise, par gravure, du réseau de motifs dans un substrat sous-jacent à ladite couche.
- Selon un exemple, le moule est un moule souple. Il est déformé, par exemple par lamination, pour répliquer ces reliefs dans la couche de résine.
- Selon un exemple, fournir le moule comprend les étapes suivantes :

  ∘ réaliser un master présentant des reliefs correspondants aux reliefs du moule,
  ∘ transférer les reliefs du master dans le moule par l'une des techniques suivantes: lithographie, impression nanométrique.

- Selon un exemple, ladite couche est une résine, de préférence thermodurcissable ou polymérisable.

Dans le cadre de la présente invention, on qualifie de dispositif microélectronique tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...). Il peut s'agir d'un dispositif destiné à assurer une fonction électronique, optique, mécanique etc. Il peut aussi s'agir d'un produit intermédiaire uniquement destiné à la réalisation d'un autre dispositif microélectronique. Ainsi, un dispositif microélectronique peut être un moule pour nanoimpression ou un empilement comprenant des motifs destinés à être transférés par gravure dans une autre couche. Il peut également s'agir d'un dispositif micro-électronique fonctionnel.

Dans le cadre de la présente invention, on qualifie de résine un matériau organique ou organo-minéral pouvant être mis en forme par une exposition à un faisceau d'électrons, de photons, de rayons X, un faisceau de lumière dans la gamme des ultraviolets, des extrêmes ultraviolets (UEV) ou des ultraviolets profonds (Deep UV) typiquement dans la gamme de longueurs d'onde de 193 nm à 248 nm, les raies d'émissions d'une lampe mercure, soit : 365 nm pour la I line, 435 nm pour la G line et 404 nm pour la H line. L'invention s'applique également aux résines qui peuvent être mises en forme mécaniquement, notamment par impression assistée thermiquement ou par ultraviolets.

On qualifie de déformable une résine qui peut être mise en forme mécaniquement, notamment par impression assistée thermiquement ou par ultraviolets.

On peut citer à titre d'exemple des résines classiquement employées en microélectronique, des résines à base de méthacrylate (par exemple le Polymethyl methacrylate PMMA), de polyhydroxystyrène (PHS). On peut également citer les familles de résines novolak, epoxy et acrylate.

Dans la présente demande de brevet, l'épaisseur d'une couche est mesurée selon une direction perpendiculaire à plan dans lequel s'étend principalement une face du substrat sur lequel repose la couche. Sur les figures, cette épaisseur est mesurée selon la direction z du repère orthogonal xyz.

Dans la présente demande de brevet, une inclinaison $\alpha$ formée par une paroi ou un flanc d'un motif correspond à l'angle formé entre la surface sur laquelle repose cette couche et la tangente à cette paroi ou ce flanc au point considéré.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

De même, lorsque l'on indique qu'un motif ou qu'une structure surmonte un substrat, cela peut signifier que le motif ou la structure sont directement au contact du substrat ou bien qu'une ou plusieurs couches sont interposées entre le motif ou la structure et le substrat.

Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

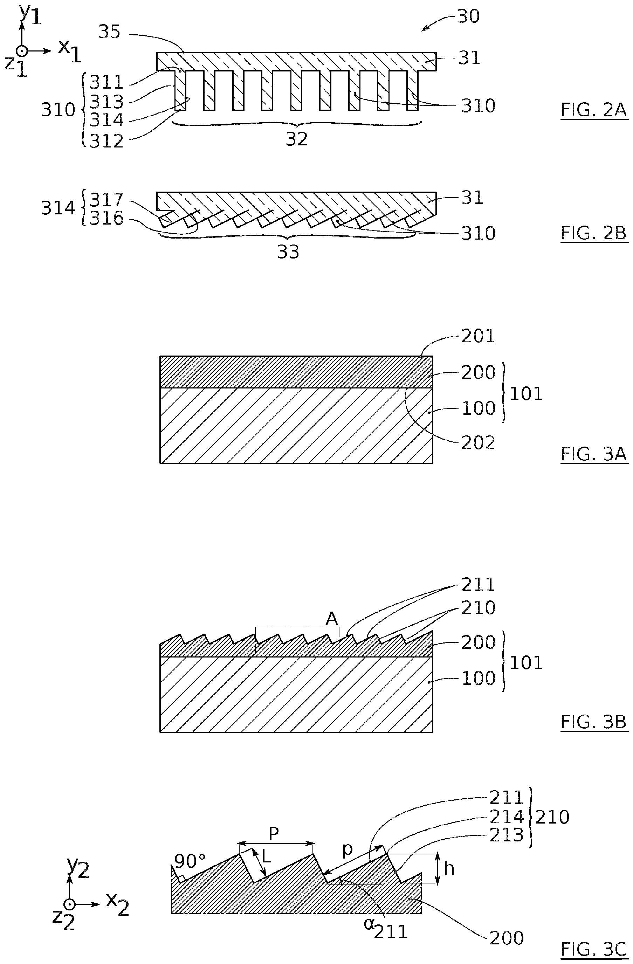

L'invention va maintenant être décrite en référence aux figures 2A à 18B.

Comme cela sera décrit en détail par la suite, le procédé proposé utilise la capacité de reliefs formés dans un matériau déformable à s'incliner et s'effondrer pour entrer en contact les uns avec les autres et ainsi former un réseau blazé, c'est-à-dire un réseau de reliefs inclinés.

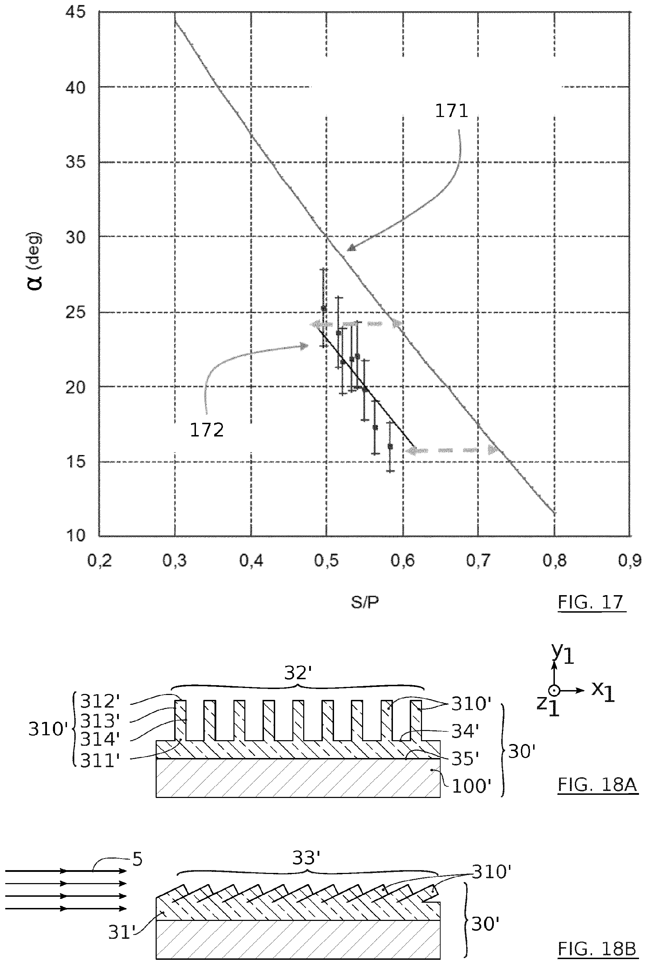

Selon un mode de réalisation illustré en figures 2A à 17, le dispositif micro-électronique dont on va contrôler l'effondrement des reliefs est destiné à former un moule pour nanoimpression. Un autre mode de réalisation, illustré en figures 18A et 18B, concerne la réalisation d'un dispositif micro-électronique comprenant un substrat surmonté d'une couche de résine portant les reliefs dont on contrôle l'effondrement.

Les figures 2A et 2B illustrent de manière schématique la réalisation d'un moule 30 pour nanoimpression présentant un réseau 33 de reliefs 310 inclinés. Une première étape consiste à fournir un moule 30 présentant des reliefs 310 non inclinés. Ces reliefs 310 présentent au moins une paroi 313, 314 s'étendant depuis une extrémité proximale 311 au contact d'une base 31 du moule 30 et jusqu'à leur extrémité distale 312. Les reliefs 310 forment un réseau 32.

Chaque relief 310 s'étend au moins selon une direction $y_1$ perpendiculaire à un plan $z_1x_1$ dans lequel s'étend principalement une face 35 du moule 30.

Chaque relief 310 peut former un plot. Dans ce cas, la section de chaque relief 310, selon un plan parallèle au plan $z_1x_1$, présente une forme polygonale, ovoïdale ou circulaire. De préférence, chaque plot présent une section constante le long de l'axe $z_1$.

Selon un autre exemple, chaque relief 310 forme une ligne droite. Dans ce cas, cette ligne peut s'étendre principalement selon une direction $z_1$ parallèle au plan $z_1x_1$. Dans le cadre de la présente invention, on qualifie de ligne ou de relief en ligne, un relief formant une nervure ou une tranchée s'étendant principalement selon une direction parallèle à une face de la couche supportant ce relief. Selon encore un autre exemple, chaque relief forme une ligne courbe.

Comme illustré en figure 2B, on effectue un effondrement contrôlé des reliefs 310 de sorte à ce que ces derniers entre en contact les uns avec les autres. Une première portion 316 de paroi 314 d'un relief 310 donné se trouve alors recouverte par la paroi 313 d'un relief qui lui est adjacent. Dans le prolongement de cette première portion 316, la paroi 314 présente une deuxième portion 317 qui, elle, n'est pas recouverte par le relief adjacent. Cette deuxième portion accessible depuis l'extérieur forme un profil incliné.

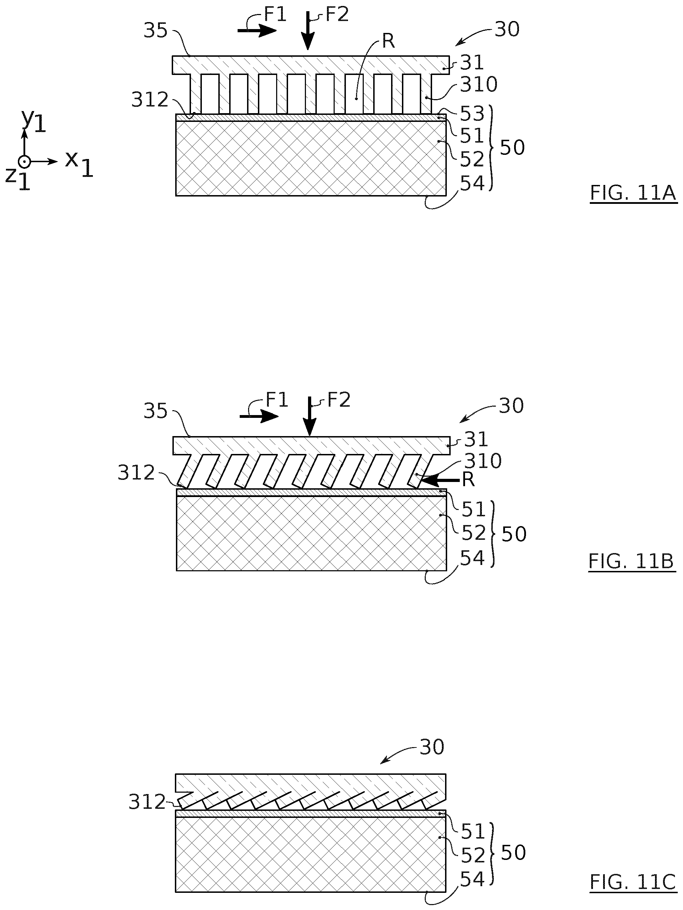

Cet effondrement résulte d'une mise sous contrainte des reliefs 310. Plusieurs exemples pour réaliser cet effondrement des motifs seront décrits en détail dans la suite de la description et en référence notamment aux figures 11A à 12E. La position inclinée des reliefs 310 obtenue après effondrement est rémanente, i.e, elle subsiste après suppression de la contrainte appliquée sur le moule 30. Ainsi, les reliefs ne reviennent pas à leur position initiale après suppression de la contrainte.

On obtient ainsi un moule 30 présentant sur l'une de ces faces un réseau 33 de motifs 310 inclinés.

Les figures 3A à 3C illustrent l'utilisation du moule 30 avec un empilement 101 comprenant un substrat 100 supportant une couche 200 déformable. La couche 200 déformable présente une face 201 tournée vers l'extérieur et une face 202 tournée vers le substrat 100. La couche 200 est de préférence une résine.

La figure 3B illustre le transfert par impression nanométrique des reliefs 310 du moule 30 dans la résine 200 de l'empilement 101. Lorsque le moule 30 est retiré de la résine 200, il laisse comme empreinte dans cette dernière un réseau de motifs 210 correspondant à l'inverse du réseau 33 porté par le moule 30.

Les motifs 210 formés dans la résine présentent chacun au moins un flanc 211 incliné d'un angle $\alpha211$ différent de 90° par rapport à un plan $z_2x_2$ dans lequel s'étend principalement la deuxième face 202 de la couche 200.

Le réseau de motifs 210 formés dans la couche 200 de résine se caractérise par plusieurs paramètres illustrés en figure 3C dont notamment :

- l'angle $\alpha211$ d'inclinaison du flanc 211 des motifs 210,
- un pas P du réseau des motifs 210,
- une hauteur h des motifs, correspondant à la plus grande distance entre sommets et creux des motifs 210,
- une longueur p des motifs, mesurée selon une direction parallèle à l'arête formée par le flanc 211 des motifs 210 selon une coupe $x_2y_2$.
- une longueur L d'une paroi 213 formant avec le flanc 211 un sommet 214 pour le motif.

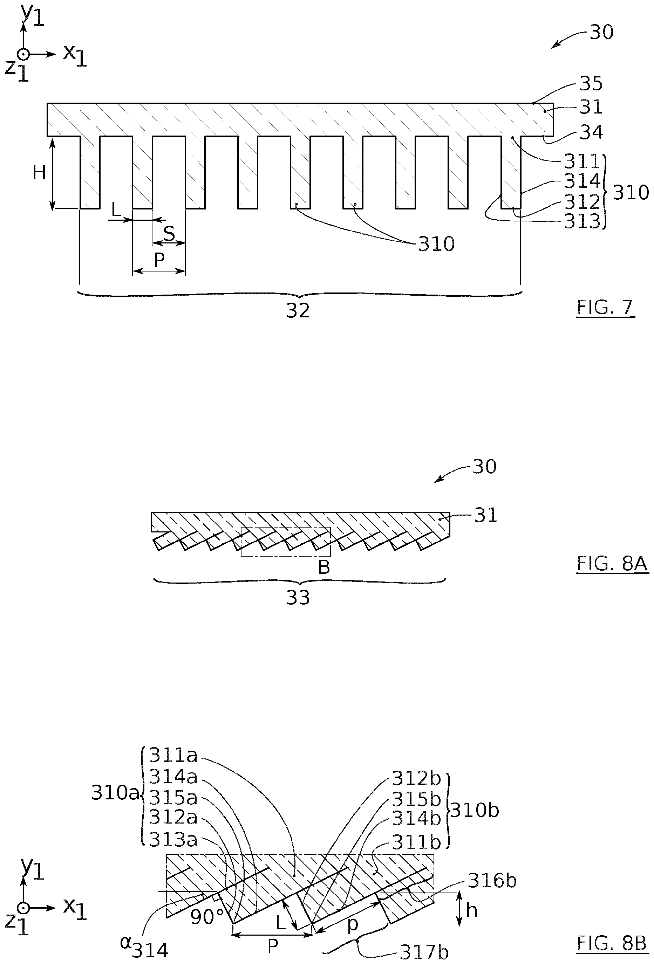

L'obtention des valeurs souhaitées par ces paramètres sera notamment fonction de la géométrie du moule 30, comme cela sera décrit plus en détail en référence aux figures 7 à 8B.

On notera qu'il est possible d'obtenir des motifs 210 dont le sommet 214, défini par le flanc 211 et la paroi 213, forme un angle droit. Cet angle droit reproduit l'angle droit formé par chaque paroi 313, 314 avec l'extrémité distale 312 des reliefs 310 du moule 30. Comme cela apparait sur la figure 3C, le flanc 211 et la paroi adjacente 213 d'un même motif présentent alors des inclinaisons dissymétriques par rapport à une normale au plan dans lequel s'étend principalement la couche 200.

Naturellement, si les extrémités distales 312 des reliefs ne forment pas un angle droit avec les parois 313, 314 des reliefs 310 du moule 30, alors les motifs 210 ne formeront pas un angle droit.

Par ailleurs, on notera que le flanc 211 peut être parfaitement lisse. Il correspond à l'empreinte laissée dans la couche 200 par la portion 317 du relief 310 du moule 30. Ainsi, ce flanc 211 ne présente pas de rugosité comme cela serait le cas avec une solution basée sur la formation d'un profil en marches d'escalier.

Plusieurs modes de réalisation d'un moule 30 vont maintenant être décrits en détail.

Selon une première étape, on réalise une structure dénommée master 40. De préférence, cette structure est réalisée dans des matériaux compatibles avec les techniques de salle blanche pour des procédés de structuration de micro et nanotechnologies.

Selon un exemple, le master 40 est à base de silicium. De préférence il est formé de silicium. Ce master présente une structuration, également désignée reliefs, qui peut être organisée sous forme de réseau(x) 42.

Le réseau 42 de ce master 40 est ensuite transféré dans un matériau déformable, de préférence un polymère, par l'une des techniques de nanoimpression. Les techniques de nanoimpression, regroupent notamment les procédés basés sur un emboutissage à chaud et les procédés de réplication assistés par ultraviolets (UV).

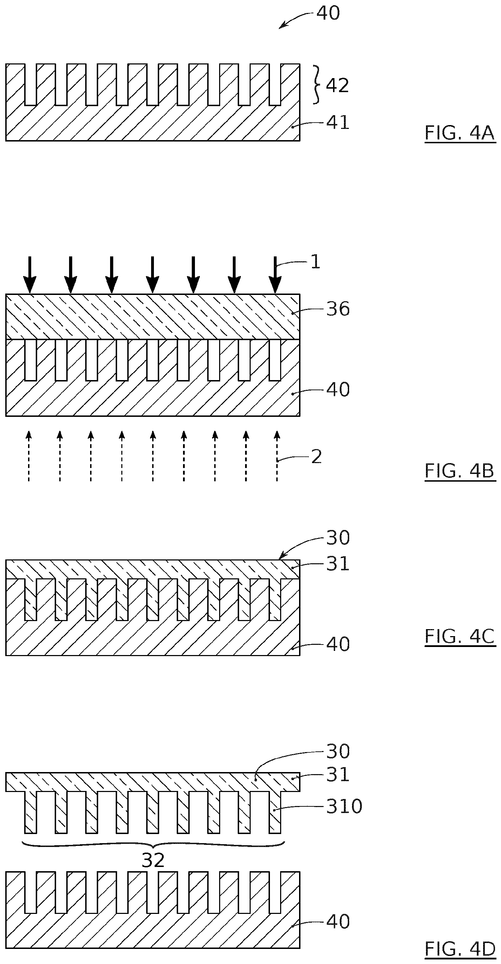

Les figures 4A à 4D illustrent des étapes d'un procédé de nanoimpression par emboutissage à chaud. La figure 4A illustre le master 40. On applique ensuite une couche 36 sur le réseau 42 de reliefs du master 40. On exerce une pression 1 sur l'un au moins parmi la couche 36 et le master 40 de sorte à ce que la couche 36 pénètre à l'intérieur des creux formés par le réseau 42 de reliefs. De préférence, on applique de la chaleur 2, par exemple depuis sur une face arrière de la base 41 du moule 40, afin de faciliter la mise en forme de la couche 36.

Comme illustré en figure 4C, une partie de la couche 36 pénètre dans les creux du réseau 42. La couche 36 présente alors la forme que l'on souhaite donner au moule 30.

Comme illustré en figure 4D, on retire ensuite le moule 30. Pour cela, on s'assure que ce dernier soit suffisamment durci. La suppression du chauffage appliqué lors de l'étape d'emboutissage facilite le durcissement du moule 30.

Le moule 30 présente alors une base 31 depuis laquelle s'étendent les reliefs 310, ces derniers formant un réseau 32 inverse de celui du master 40.

Dans ce mode de réalisation, le moule est par exemple formé principalement, ou uniquement d'un matériau thermoplastique.

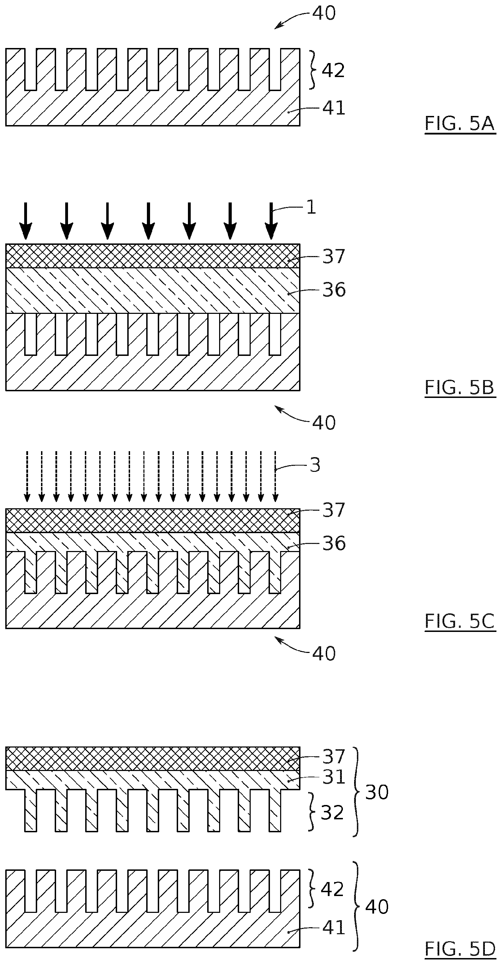

Les figures 5A à 5D illustrent des étapes d'un procédé de nanoimpression par impression UV, également désigné réplication UV.

Sur le master 40 de la figure 5A, on applique un empilement, préalablement réalisé, comprenant au moins:

- une couche 36 imprimable, de préférence à température ambiante, dont une face est tournée au regard des reliefs du master 40,
- un substrat de support, également désigné substrat poignée 37. Il peut s'agir d'un film polymère.

Comme illustré en figure 5B, on applique une pression sur une face arrière du substrat poignée 37 de sorte à presser la couche 36 imprimable contre les reliefs du master 40.

Lorsque le matériau imprimable de la couche 36 a pénétré dans les creux formés par les reliefs du master 40, on applique un flux lumineux, typiquement un flux ultraviolet sur cette couche 36, à travers le substrat poignée 37. Cette insolation permet un durcissement du matériau de la couche 36. Comme illustré en figure 5D, on peut alors retirer le moule 30 ainsi formé, qui présente un réseau 32 de reliefs, inverse du réseau 42 du master 40.

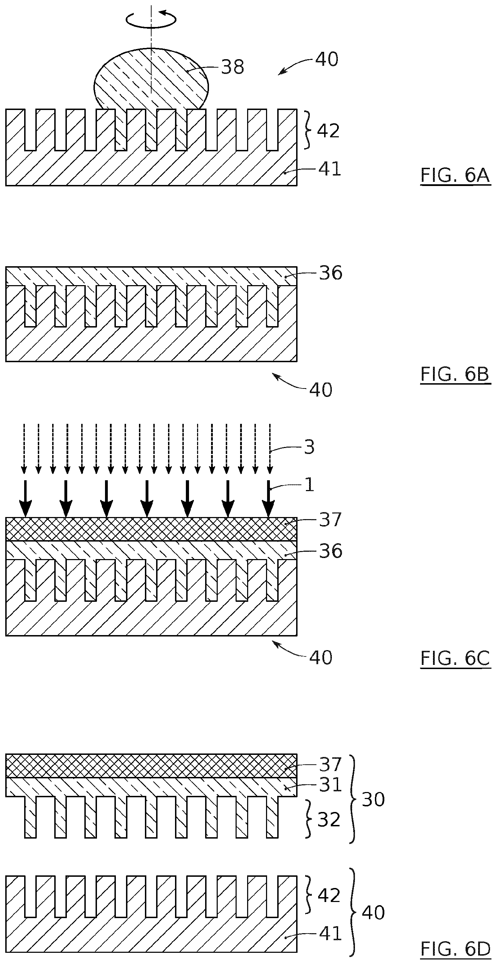

Les figures 6A à 6D illustrent des étapes d'un autre procédé de nanoimpression par impression UV.

Sur le master 40 de la figure 6A, on dépose un matériau déformable 38. Par centrifugation (spin coating) on étale ce matériau 38 sur la surface du master 40. Ainsi, le matériau déformable emplit les creux du réseau 42 du master 40. On dépose alors un substrat poignée 37 sur une face restée libre de la couche 36 étalée.

Comme illustré en figures 6C, de préférence, on applique une pression sur la face arrière du substrat poignée 37. De préférence également, on effectue une étape d'insolation, par exemple par UV, pour durcir le matériau de la couche 36. Comme illustré en figure 6D, on peut alors retirer le moule 30 ainsi formé, qui présente un réseau 32 de reliefs, inverse du réseau 42 du master 40.

Les figures 7, 8A et 8B illustrent en détail un moule 30 avant effondrement des reliefs et après effondrement des reliefs.

La figure 7 montre plusieurs paramètres géométriques du réseau 32 initial, c'est-à-dire avant effondrement des reliefs 310. Le réseau initial 32 de reliefs 310 se caractérise par plusieurs paramètres dont notamment les dimensions suivantes :

- une hauteur H des reliefs 310, correspondant à la distance entre l'extrémité proximale 311 et l'extrémité distale 312 des reliefs 310. Cette hauteur H est mesurée dans cet exemple selon la direction $y_1$; cette direction correspond à la direction d'extension principale des reliefs 310.
- une largeur L des reliefs, prise selon la direction $x_1$. Lorsque les reliefs 310 forment des lignes s'étendant selon la direction $z_1$, cette largeur correspond à la distance entre deux parois 313, 314. Lorsque les motifs forment des plots circulaires, L correspond au diamètre des plots ;
- un espacement S entre deux reliefs 310 consécutifs ;
- un pas P du réseau 42 de reliefs. P = L + S.

À partir du moule de la figure 7, on provoque l'effondrement des reliefs 310 les uns sur les autres. L'angle d'effondrement ainsi que les dimensions géométriques des reliefs de départ permettent alors de former le réseau blazé ou incliné 33.

Le réseau incliné 33 se caractérise par plusieurs paramètres dont notamment les dimensions suivantes déterminées par le réseau initial 32 :

- l'angle $\alpha$314 d'inclinaison des parois 314 des reliefs 310. Cet angle $\alpha$314 se mesure par rapport au plan $z_1x_1$. Cet angle $\alpha$314 est égal à l'angle $\alpha$211 des motifs 210 formés dans la couche déformable 200, comme illustré en figure 3C. Par souci de concision, dans la suite de la description ces angles $\alpha$314 et $\alpha$211 seront désignés sous la seule notation $\alpha$.
- la longueur p des parois 314 des reliefs 310. Cette longueur p correspond à la deuxième portion 317 de la paroi 314 non recouverte par le relief adjacent. Cette longueur p correspond également à la longueur p du flanc 211 des motifs 210 formés, après impression du moule 30, dans la couche 200 de résine comme illustré en figure 3C.
- le pas P du réseau 33 de reliefs. Le pas P peut, après effondrement, être mesuré entre les sommets 315 de deux reliefs 310 adjacents. Ce pas P du réseau 33 de reliefs 310 correspond au pas P du réseau de motifs formés après nanoimpression dans la couche 200 de résine, comme cela est illustré en figure 3C.
- la largeur L des reliefs 310, formant après effondrement, la longueur d'une paroi 312 définissant avec la portion 317 un sommet 315 pour le relief 310.
- la hauteur h des reliefs 310, correspondant à la distance entre sommets 315 et creux des reliefs 310. Cette hauteur h des reliefs 310 correspond à la hauteur h des motifs 210, comme illustré en figure 3C.

Il est possible d'établir une relation entre les angles $\alpha$ du réseau blazé et les caractéristiques géométriques du réseau initial 32 du moule 30. En effet :

$$\cos(90 - \alpha) = 1 - \frac{S}{P}$$

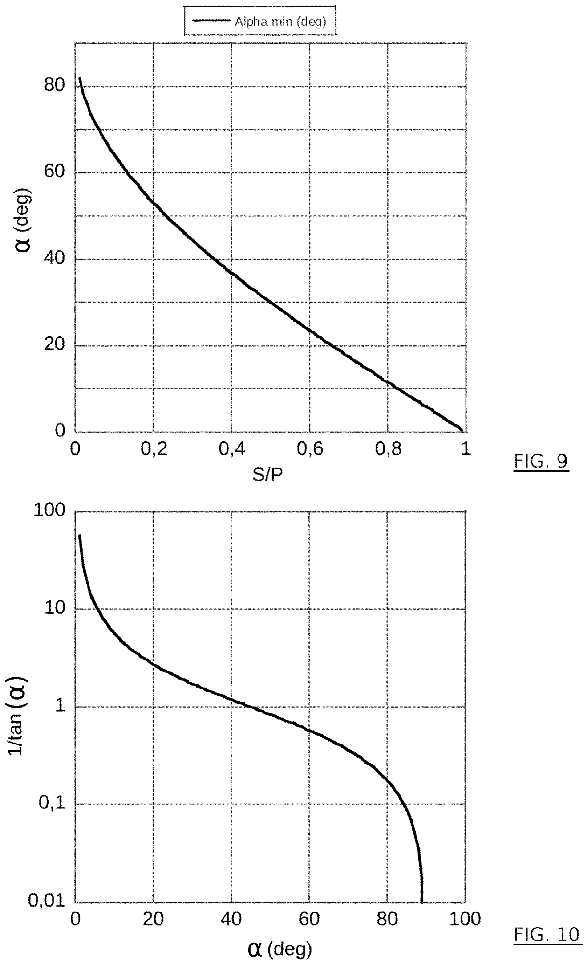

Ainsi il est possible de déterminer les angles accessibles avec cette approche. Ces angles peuvent être déterminés à partir de la figure 9 qui illustre le domaine d'angles accessibles pour les réseaux inclinés en fonction du rapport S/P.

On détermine l'angle que l'on souhaite avoir sur le réseau incliné 33 du moule (ou sur le réseau de la couche 200 de résine) et l'on peut ensuite déterminer le rapport S/P (espace entre deux reliefs et période P du réseau initial 32).

Le rapport L/P est alors égal à :

$$\frac{L}{P} = 1 - \frac{S}{P}$$

Par ailleurs selon l'utilisation finale du réseau incliné 33, la hauteur h sera choisie et permet alors de déterminer la valeur de L via la relation suivante :

$$L = \frac{h}{\cos(\alpha)}$$

L'utilisateur déterminant h (ou la période du réseau blazé) et $\alpha$, cela permet de déterminer de façon unique L et S (et donc P). Par ailleurs, pour que deux reliefs adjacents soient en contact après leur effondrement il est préférable de respecter la condition suivante sur H :

$$H > p = \frac{L}{\tan(\alpha)}$$

Ainsi, en fonction des procédés de structuration mis en œuvre pour fabriquer le master 40, il faudra s'assurer que le rapport de forme H/L (hauteur H sur largeur L) des reliefs du master 40 respecte cette condition :

$$\frac{H}{L} > \frac{1}{\tan(\alpha)}$$

La figure 10 correspond à la fonction 1/tan(a).

Il est à noter que plus le rapport de forme H/L est grand, plus il est alors aisé de réaliser l'effondrement des reliefs 310. Par conséquent, la mise en œuvre du procédé proposé sera d'autant plus facile que H/L est largement supérieur à 1, ce qui se traduit par des angles $\alpha$ pour les réseaux blazés 33 inférieurs à 45°. Avantageusement, dès que le rapport de forme est supérieur à 3, l'effondrement des reliefs 310 est grandement facilité de par le comportement des résines usuellement utilisées en lithographie et de par leurs propriétés mécaniques.

On veillera naturellement à ce qu'il n'y ait pas de particules contaminantes qui viendraient volontairement se déposer entre les reliefs avant effondrement.

De préférence, la résine est poreuse à l'air. Ce dernier peut ainsi s'échapper au travers de la matière et permet aux flancs de deux reliefs adjacents de venir en contact l'un de l'autre.

Lors de l'effondrement, il peut y avoir à la fois, rotation et déformation/déplacement de la matière de la couche, typiquement la couche de résine.

De préférence, le moule est un moule souple. Il peut être appliqué sur la couche 200 de résine par lamination, par exemple à l'aide d'un rouleau.

Afin d'obtenir une inclinaison contrôlée et rémanente des reliefs du moule le matériau formant les reliefs et choisis de sorte à ce qu'une fois les reliefs effondrés, le matériau composant ses relief colle à lui-même. Ainsi, une fois les reliefs couchés et plaqués les uns contre les autres, ils restent en position.

De préférence, la résine est poreuse à l'air. Cela permet notamment d'éviter la formation de cavités remplies d'air à l'intérieur. Cette porosité de la résine se mesure par la perméabilité (mesuré en Barrer). Dans notre cas il est avantageux que cette perméabilité au $CO_2$ (souvent gaz de mesure) soit supérieure à 10 Barrer.

Plusieurs modes de réalisation vont maintenant être décrits pour provoquer contrôler l'effondrement des motifs.

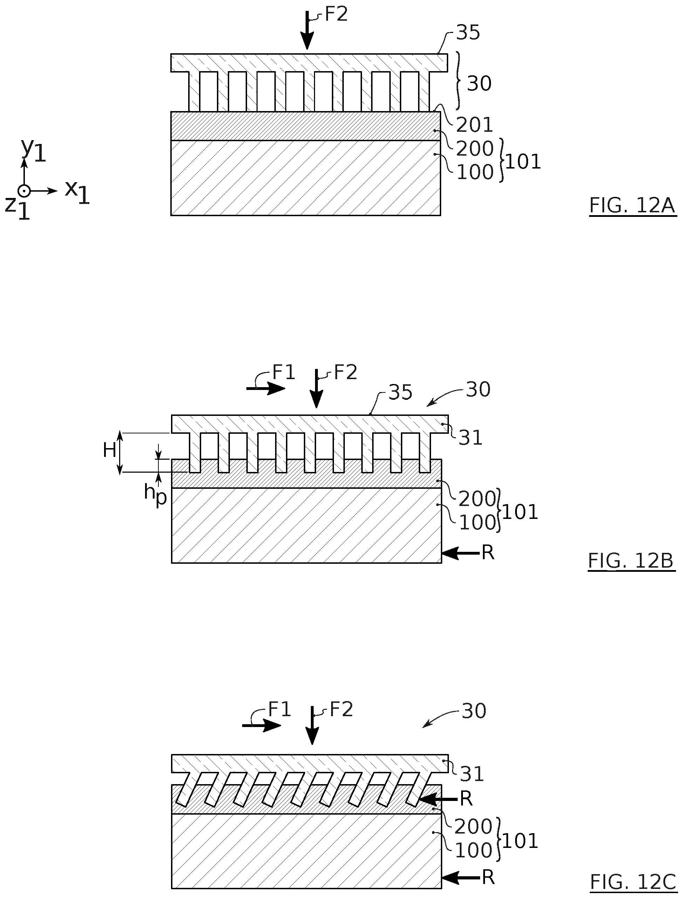

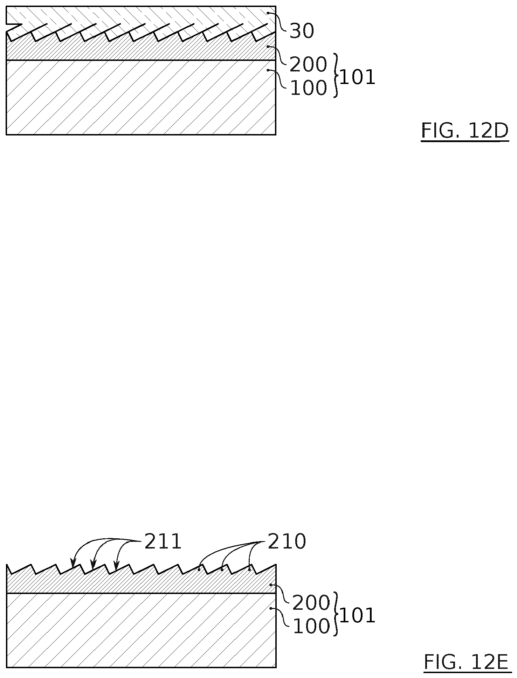

Selon une première approche, l'effondrement des motifs est obtenu par application de forces de contact sur la base 31 du moule 30 et sur les reliefs 310. Cette première approche sera illustrée par référence à deux modes de réalisation illustrés respectivement en figures 11A à 11F et 12A à 12E.

Le premier mode de réalisation consiste à utiliser un substrat intermédiaire 50, également désigné substrat de lamination, afin de provoquer l'effondrement des reliefs 310.

Comme illustré en figure 11A, la face avant du moule 30, celle portant les reliefs 310 est mise en contact avec le substrat intermédiaire 50. Plus précisément, les extrémités distales 312 des reliefs 310 sont au contact d'une face avant 53 du substrat intermédiaire 50. On applique ensuite sur une face arrière 35 du moule 30 simultanément :

- une force F1 parallèle à la face arrière 35 du moule 30, afin d'entraîner un déplacement relatif entre la base 31 du moule 30 et le substrat intermédiaire 50, alors que l'extrémité distale 312 des reliefs 310 demeure en contact avec le substrat intermédiaire 50. Ce dernier constitue donc un point d'ancrage à partir duquel les reliefs 310 vont se déformer. Ainsi, au niveau de l'extrémité distale 312 des reliefs 310, la face 53 du substrat intermédiaire 50 applique sur ces derniers une force de réaction R. Cette force F1 est parallèle à la face arrière 35 du moule 30 c'est-à-dire parallèle au plan z1x1.
- une force F2 normale à la face arrière 35 du moule 30 et du substrat intermédiaire 50. Plus généralement, la force F2 est appliquée parallèlement à la direction principale selon laquelle les reliefs s'étendent dans le plan x1y1 avant l'étape de couchage. Cette force F2 et de préférence appliquée de sorte à permettre un contact conforme, c'est-à-dire un contact et une force de contact homogène sur tous les reliefs 310. C'est également le contrôle de cette force F2 qui permet d'assurer l'ancrage des extrémités distales 312 des reliefs 310 sur le substrat intermédiaire 50. Cette force F2 est perpendiculaire au plan z1x1.

De préférence, la force F2 est appliquée simultanément à la force F1. Dans ce cas, on peut prévoir qu'un même actionneur applique un effort présentant au moins les composantes F1 et F2.

La figure 11B illustre les reliefs 310 en cours de déformation.

La figure 11C illustre les reliefs lorsque les reliefs 310 sont complètement effondrés les uns sur les autres.

De préférence, la face 53 du substrat intermédiaire 50 est rigide. De préférence également, elle ne présente que peu ou pas d'adhérence avec le matériau organique utilisé pour la fabrication du moule 30.

À cet effet, on peut prévoir que le substrat intermédiaire 50 comprenne ou soit formé d'un substrat de base 52 recouvert d'un film 51 antiadhésif. Ce film 51 présente un coefficient de friction inférieur ou égal à 0,01. Il est par exemple formé d'un matériau organique fluoré.

Selon un exemple, ce substrat intermédiaire 50 est transparent de sorte à ce que l'on puisse optiquement suivre par sa face arrière 54 l'effondrement de reliefs 310. Par exemple, le substrat intermédiaire 50 est formé ou comprend un substrat de base 52 formé d'une tranche (wafer) de silicium ou de verre.

Une fois l'effondrement des reliefs 310 obtenu, le moule 30 est détaché du substrat intermédiaire 50.

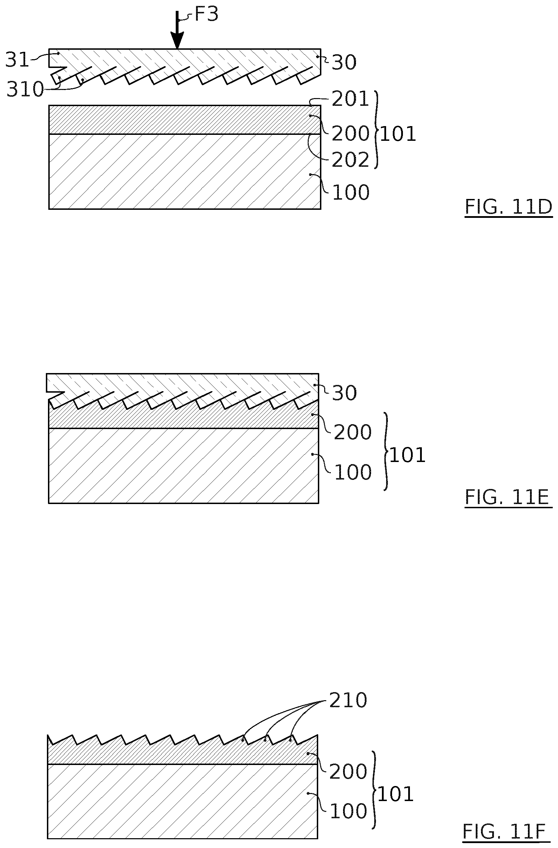

Le moule 30 est alors utilisé pour imprimer une couche 200 de résine déposée sur un autre empilement 101 en utilisant les procédés d'impression bien connus de l'homme du métier (e.g., impression thermique ou assistée par UV). Ces étapes sont illustrées en figure 11D et 11E. La figure 11F illustre le résultat obtenu en fin d'impression de la couche 200 de résine 210. Cette dernière présente des motifs 210 inverse des reliefs 310 du moule 30.

Cette première approche avec utilisation d'un substrat intermédiaire 50 offre un très bon contrôle du procédé et en particulier de l'inclinaison progressive des reliefs 310.

Une deuxième approche, illustrée en référence aux figures 12A à 12E va maintenant être décrite. Cette deuxième approche prévoit d'initier l'effondrement des reliefs 310 pendant la phase de remplissage du moule 30, c'est-à-dire lorsque les reliefs 310 ont déjà en partie au moins pénétré dans la couche 200 à imprimer.

Cette deuxième approche présente pour avantage de favoriser l'effondrement des reliefs 310. Par ailleurs, elle permet de réduire le nombre d'étapes et rend le procédé de réalisation plus rapide et moins coûteux.

Comme illustré en figure 12A, on place les reliefs 310 du moule 30 au contact de la couche 200, typiquement une résine imprimable. On applique une force F2 perpendiculaire au plan principal z1x1 dans laquelle s'étend la face 201 de la couche 200. Cette force F2 fait pénétrer les reliefs 310 du moule 30 dans la couche 200 comme illustré en figure 12B. Les extrémités distales des reliefs 310 sont alors ancrées dans cette couche 200. On applique une force F1 parallèle au plan de la face 201 sur l'un parmi le moule 30 ou le substrat 101 et une force opposée, par exemple un effort de réaction, sur l'autre parmi le moule 30 ou le substrat 101. Cet effort de réaction est par exemple engendré par un équipement de maintien. De préférence, la force F1 est de préférence appliquée sur la base 31 du moule 30 et l'effort de réaction R est appliqué sur le l'empilement 101.

Cette force F1 et sa force opposée provoquent un déplacement relatif entre la base 31 du moule 30 et l'extrémité des reliefs 312 piégés dans la couche 100. Il s'ensuit une déformation des reliefs 310 qui viennent se coucher les uns sur les autres comme illustré en figure 12C et 12D.

Selon un exemple, la force F2 est appliquée simultanément à la force F1. Dans ce cas, on peut prévoir qu'un même actionneur applique un effort présentant au moins les composantes F1 et F2. Selon un mode de réalisation alternatif, la force F1 est appliquée après suppression de la composante F2 et après ancrage de l'extrémité distale 312 des reliefs au sein la couche 200.

La couche 200 est de préférence stabilisée par ultraviolets et/ou thermiquement.

Le moule 30 est ensuite retiré de la couche 200. On obtient alors sur une couche 200 des motifs 210 présentant chacun un flanc incliné.

De préférence, l'épaisseur de la couche 200 de résine est suffisamment importante pour permettre un remplissage total des cavités formées entre les reliefs 310 du moule 30 souple.

De préférence, dans ce mode de réalisation, on initie l'effondrement des reliefs 310 après avoir fait pénétrer une portion suffisante de leur hauteur totale H dans la couche 200. Si hp est la portion de hauteur insérée dans la couche 200 avant de débuter l' effondrement, on respecte de préférence la relation suivante $1\%*H \leq hp \leq 15\%*H$ et $3\%*H \leq hp \leq 10\%*H$.

Par ailleurs, de préférence $1 \leq hp \leq 20$ nm (10-9 mètres) et de préférence $1 \leq hp \leq 10$ nm (10-9 mètres).

Cela permet d'assurer un bon ancrage de l'extrémité distale 312 des reliefs 310 tout en autorisant un bon contrôle de la déformation des reliefs 310.

Pour chacun des modes de réalisation décrits précédemment, on prévoit que le moule 30 soit muni d'un revêtement anti adhésif afin de faciliter le démoulage. De préférence ce traitement antiadhésif est sous forme d'un revêtement recouvrant tout au moins les reliefs 310 du moule 30.

Ce traitement permet de réduire significativement les risques d'adhésion des reliefs du moule sur la couche 200.

Ce traitement est particulièrement avantageux si les surfaces du moule et de la couche 200 présentent des matériaux identiques ou proches tels que des matériaux minéraux ou organiques. Par ailleurs, ce revêtement antiadhésif est d'autant plus important dans le mode de réalisation décrit en référence aux figures 12A à 12D pour éviter que de la résine de la couche 200 reste piégée entre les reliefs 310 lors de l'effondrement de ces derniers.

Ce traitement antiadhésif est par exemple réalisé par dépôt d'un film, par exemple une monocouche, en phase vapeur ou par centrifugation (spin coating).

Selon une troisième approche, l'effondrement des reliefs est obtenu par application d'un jet sur les reliefs 310 du moule 30. On remplace ainsi la force de contact mentionnée dans les modes de réalisation précédents par une force sans contact physique qui s'exerce directement sur les reliefs. Ainsi, la contrainte exercée sur les reliefs du moule peut être une force de contact ou une force sans contact. Le jet peut être un jet de gaz comprimé tel que par exemple de l'air ou de l'azote. Alternativement, le jet peut être un jet de liquide sous pression. Il peut alors s'agir d'eau ou d'un liquide neutre pour la résine c'est-à-dire ne dissolvant pas les reliefs formés. Le jet peut présenter la forme d'un faisceau ou d'une nappe, comme illustré par la référence numérique 5 en figure 18B.

En supprimant le contact physique, ce mode de réalisation permet de réduire les risques d'apparition de défauts potentiellement créés pendant le processus de couchage et qui sont par exemple dus à la présence de poussière.

Avec une solution basée sur l'application d'une force de contact sur les reliefs destinés à être déformés, si une particule est présente sur l'objet exerçant le contact, alors, les reliefs peuvent se trouver contaminés.

En utilisant un fluide pur, c'est-à-dire sans particules contaminantes, on évite que les reliefs à déformer soient contaminés.

Par ailleurs, par rapport aux modes de réalisation décrits en référence aux figures 11A à 11C on réduit le risque de défaut causé par un contact insuffisant ou inhomogène entre l'extrémité distale 312 des reliefs 310 et le substrat intermédiaire 50.

## Premier exemple de réalisation

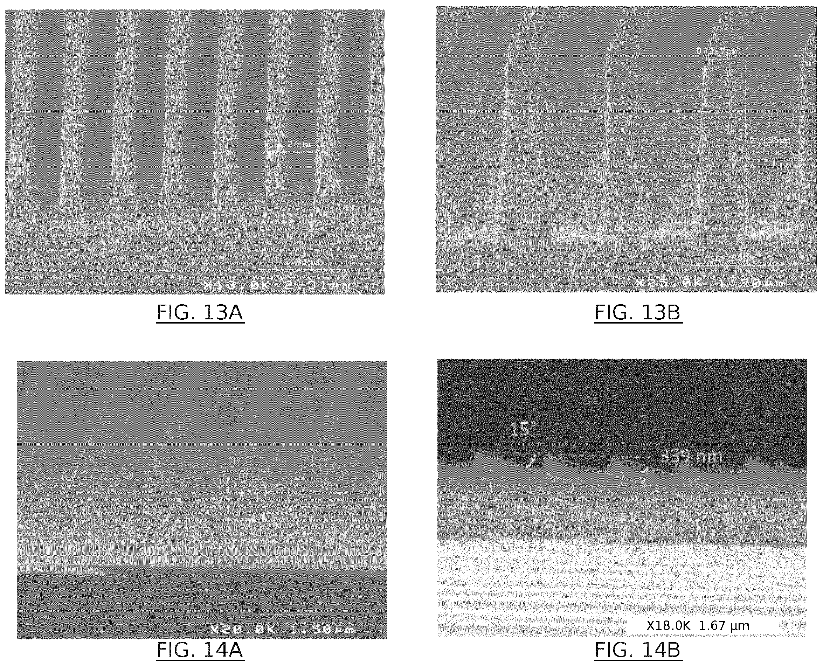

Un premier exemple de réalisation, non limitatif, va maintenant être décrit en référence aux figures 13A à 14B.

Une première étape consiste à fabriquer une structure master. Ce master est réalisé dans un substrat de silicium en utilisant les procédés de structuration des micro-technologies et nanotechnologies, par exemple lithographie optique et gravure sèche par plasma. Ce master présente un réseau de lignes telles que cela apparaît sur les images des figures 13A et 13B.

Les dimensions du réseau de lignes sont les suivantes :

- L = 329 nm
- S = 931 nm
- P = 1,26 $\mu$m
- H = 2,155 $\mu$m

On transfère ensuite l'inverse des reliefs de ce master dans un moule en appliquant un procédé d'impression thermique à chaud.

Le moule est réalisé à partir d'une couche déformable, de 250 $\mu$m d'épaisseur, faite de COC (cyclo oléfine copolymère).

L'impression thermique à chaud est réalisée à une température de 160°C pendant 5 minutes avec une pression de 20 bars. Une fois l'ensemble, master et couche de COC refroidi à une température inférieure à 60°C, ils sont séparés.

Le moule ainsi formé est ensuite utilisé pour imprimer une couche 200 faite d'un film de résine. La résine est par exemple la résine MRL 6000 fabriquée par l'entreprise Micro Resist Technology™. La couche 200 présente une épaisseur de 2,0 $\mu$m. Elle est déposée par centrifugation sur un substrat 100 de silicium. La couche 200 et le substrat 100 forme une plaque ou empilement 101.

Le moule, de préférence, par exemple souple, est laminé sur la plaque avec un rouleau en silicone. Cette étape de lamination peut être effectuée manuellement. Cette étape permet de mettre en contact le moule 30 avec la surface de la résine visqueuse à température ambiante. L'effet du laminage permet d'exercer la force F1 parallèle à la surface 201 de la couche 200 de résine et du plan défini par les sommets 315 des reliefs 310 du moule 30 alors en contact avec la face supérieure 201 de la couche 200 de résine, ce qui permet de réaliser l'effondrement des reliefs. L'impression est ensuite finalisée en chauffant la résine à 50°C et avec une insolation UV (longueur d'onde 365 nm) d'une puissance de 50 mW/cm$^2$ pendant 30 secondes (flash UV) et sous une pression normale aux surfaces 201, 35 de 6 bars. Puis le moule 30 est séparé de la couche 200 de résine ainsi formée.

Pour obtenir les images des figures 14A et 14B, l'empilement 101 ainsi obtenu a été clivé pour permettre une observation au microscope électronique à balayage.

En reprenant les règles de dessins exposées précédemment on peut déterminer l'angle du réseau blazé.

$$\cos(90 - \alpha) = 1 - \frac{S}{P}$$

$$\sin(\alpha) = 1 - \frac{931}{1260} = 0.2611$$

$\alpha$ = 15.13°

Sur les mesures réalisées sur l'exemple on détermine un angle de 15° en accord avec les règles de dessin. Pour ce qui est de la valeur de p on applique les équations suivantes :

$$p = \frac{L}{\tan(\alpha)}$$

$$p = \frac{329}{\tan(15.13)} = 1216 \, nm$$

Cette valeur calculée de p est très proche de la valeur mesurée, ce qui confirme la validité des règles de dessin établies. On peut cependant noter que la hauteur initiale des reliefs sur le master (2.155 $\mu$m) est bien supérieure à la valeur théorique de p, 1.216 $\mu$m, ce qui permet le contact des lignes voisines. Par ailleurs le rapport de forme H/L étant de 6,55, l'effondrement des lignes est relativement aisé.

Dans ce cas présent, le moule souple a été réalisé dans un polymère à base d'acrylate et la résine imprimée est formulée sur une base époxy. Ce couple de famille de matériaux est donc tout particulièrement bien adapté à la mise en œuvre du procédé proposé.

**Autres exemple de réalisation**

Cette section présente différents réseaux de tranchées qui ont été fabriqués dans une plaque de silicium. Ces tranchées présentent une profondeur de gravure de 800 nm. Ces réseaux de tranchées diffèrent par leur période. Ainsi la densité de tranchée est comprise entre 0.43 et 0.5

| Réseau | C1 | C2 | C3 | C4 |
|---|---|---|---|---|
| Largeur L de tranchée (nm) | 265 | 276 | 262 | 271 |
| Période P (nm) | 545 | 602 | 589 | 627 |
| Rapport L/P | 0,49 | 0,46 | 0,458 | 0,43 2 |

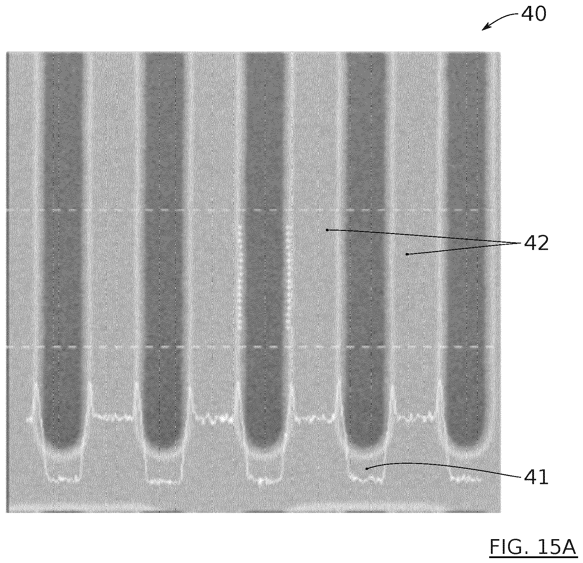

La figure 15A est une image au microscope électronique d'un exemple de master présentant un réseau de reliefs.

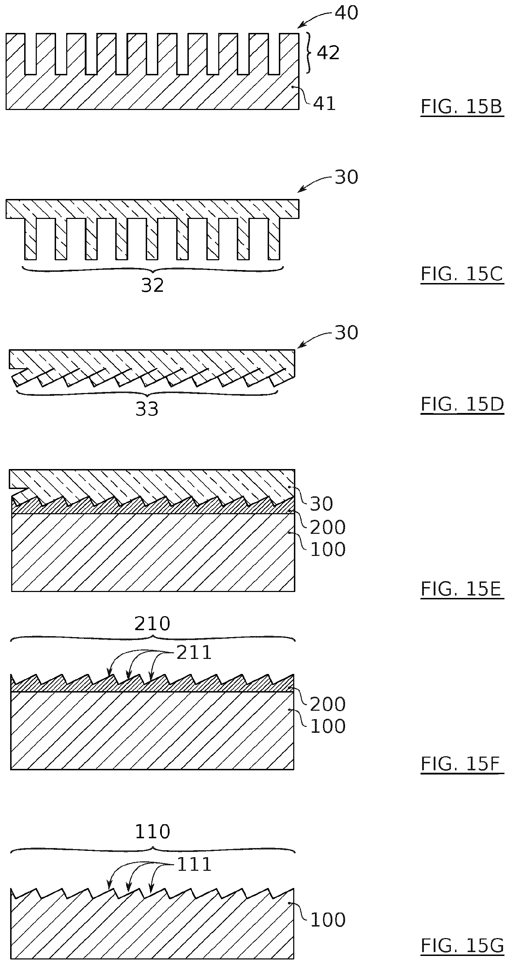

Pour chaque réseau fabriqué, on effectue les étapes illustrées en figure 15B à 15G. Ces étapes ont été décrites en détail dans la description qui précède et sont très brièvement rappelées ci-dessous :
La figure 15B illustre le master 40 et son réseau 42 de reliefs. La figure 15C illustre le moule 30 obtenu à partir du master 40. La figure 15D illustre le moule 30 après effondrement des reliefs 310 du réseau 32 pour former un réseau 33 de reliefs inclinés. La figure 15E illustre l'impression du moule 30 dans la couche 200 de résine. La figure 15F illustre le réseau de motifs 210 obtenus dans la couche 200 après retrait du moule 30. Chaque motif 210 présente un flanc 211 incliné. La figure 15G illustre le résultat obtenu après transfère des motifs 210 de la résine dans un substrat 100 sous-jacent à la couche 200.

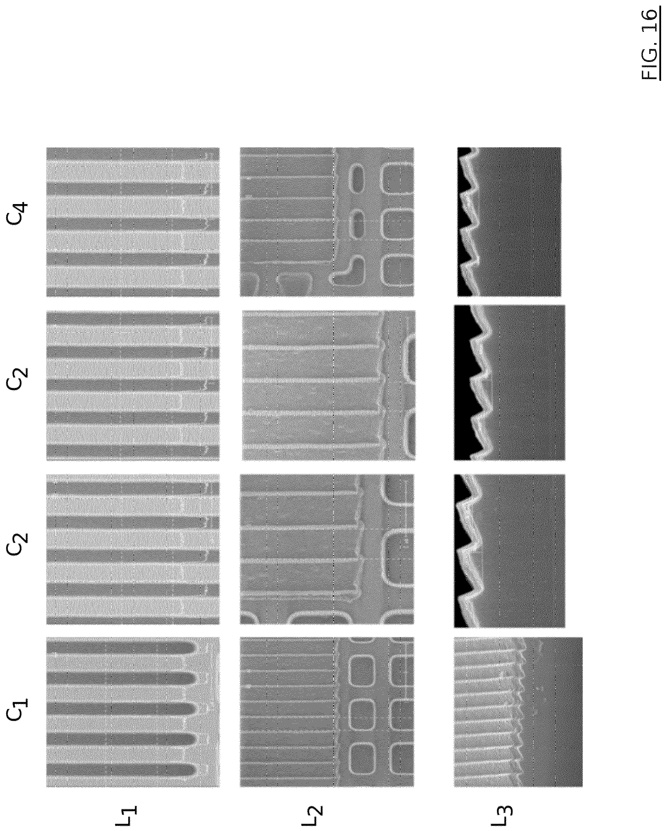

La figure 16 regroupe des images obtenues au microscope électronique en mettant en œuvre le procédé illustré en figures 15B à 15F. Les images des colonnes C1 à C4 correspondent aux différents réseaux mentionnés dans le tableau ci-dessus. Les images des lignes L1 à L3 correspondent aux images obtenues par microscopie électronique respectivement :

- en vue du dessus des masters,
- en vue du dessus des réseaux blazés imprimés dans la couche de résine,
- en vue en coupe des réseaux blazés imprimés dans la couche de résine.

A partir des images de cette figure 16, on peut constater que l'on obtient bien des réseaux blazés pour toutes ces configurations. En fonction des géométries imposées par le master il est possible d'obtenir différents angles de réseaux blazés.

On remarquera qu'il peut y avoir un décalage constant entre l'angle attendu avec les géométries imposées aux masters et l'angle mesuré. Ce décalage constant apparaît clairement sur le graphe de la figure 17. Sur ce graphe la courbe 171 représente les angles prévus avec la géométrie (design) imposées au master. La courbe 172 représente les angles effectivement obtenus dans le moule et la couche de résine.

Ce décalage est lié aux propriétés des matériaux utilisés. En effet, sous exposition UV ces matériaux subissent un certain rétrécissement ce qui affecte les dimensions des reliefs présents sur le moule et donc modifie la valeur du rapport S/P. Il en résulte un décalage constant. Il est donc avantageux, en fonction des matériaux utilisés pour générer le moule souple sur lequel les reliefs seront effondrés de passer par une étape de calibration. Cette étape de calibration vise à prendre en compte cette variation de géométrie sur les structures obtenues, puis de corriger la géométrie (design) initiale imposée au master.

**Modes de réalisations alternatifs**

Le procédé décrit ci-dessus s'applique également à la réalisation d'un dispositif micro-électronique 30' présentant un réseau 33' de reliefs inclinés qui n'est pas obtenu à partir d'un procédé de nanoimpression et/ou qui n'est pas destiné à former un moule pour nanoimpression.

En effet, le dispositif micro-électronique 30', en particulier son réseau initial 32' de reliefs 310' peut être obtenu par l'une quelconque des techniques de micro-électronique et notamment la lithographie optique (en particulier photolithographie) ou la lithographie électronique (en particulier lithographie par faisceau d'électrons) sans être limité à la nanoimpression.

Par ailleurs, le dispositif micro-électronique 30' peut former une couche de résine portant des motifs qui seront transférés dans une couche fonctionnelle, par exemple par gravure et non pas par nanoimpression.

En outre, le dispositif micro-électronique 30' peut former un dispositif fonctionnel, c'est-à-dire un dispositif présentant au moins une fonction mécanique, ou optique.

La figure 18A représente une structure 30' comprenant un substrat 100' surmonté d'une couche dans laquelle sont formés des reliefs 310' organisés sous forme d'un réseau initial 32'. Tous les éléments de cette figure 18A correspondent aux éléments portant des références numériques de même nombre dans les figures précédentes.

Comme illustré en figure 18B, on effectue ensuite une étape de couchage des reliefs 310' pour obtenir un réseau ultérieur 33' présentant des reliefs 310' inclinés.

Cette étape de couchage peut par exemple être obtenue en mettant en œuvre le procédé illustré en figure11A à 11C qui prévoit l'application d'une force de contact sur un substrat intermédiaire 50. Cette étape de couchage peut aussi être obtenue en appliquant un jet 5 de fluide sur les reliefs 310' tel que décrit ci-dessus.

Toutes les caractéristiques et tous les effets techniques mentionnés ci-dessus en référence à la réalisation d'un moule 30 pour nanoimpression sont transposables à ce mode de réalisation d'un dispositif micro-électronique 30'.

Le dispositif micro-électronique 30' ainsi obtenu peut servir au transfert du réseau 33' dans un autre substrat, par exemple par gravure. Alternativement, le dispositif micro-électronique 30' peut former un moule pour nanoimpression.

L'invention n'est pas limitée aux modes de réalisations précédemment décrits et s'étend à tous les modes de réalisation couverts par les revendications.

En particulier, le procédé proposé peut être mis en œuvre sur des reliefs ou motifs qui ne sont pas en une dimension (réseau de lignes ou de plots) comme dans les exemples non limitatifs présentés ci-dessus. Les reliefs ou motifs peuvent aussi présenter des formes plus complexes et notamment des formes en trois dimensions c'est-à-dire présentant plusieurs niveaux de hauteur. On peut ainsi créer des réseaux blazés avec une organisation et des formes complexes.

**Revendications**

1. Procédé de réalisation d'un dispositif (30, 30') microélectronique présentant un réseau ultérieur (33, 33') de reliefs (310, 310') dont au moins une paroi (313, 314, 313', 314') est inclinée, le procédé comprenant au moins les étapes suivantes:

   - fournir une structure comprenant:

      ◦ une base (31, 31'),
      ◦ un réseau initial (32, 32') de reliefs (310, 310'), chaque relief (310, 310') présentant au moins une extrémité proximale (311, 311') au contact de la base (31, 31'), une extrémité distale (312, 312') et au moins une paroi (313, 314, 313', 314') s'étendant entre l'extrémité proximale (311, 311') et l'extrémité distale (312, 312'),

   - coucher les reliefs (310, 310') du réseau initial (32, 32') les uns sur les autres, par application d'au moins une contrainte sur la structure, de sorte que des parois (313, 314, 313', 314') en regard de deux reliefs (310, 310') adjacents entrent au contact, générant ainsi au moins un réseau ultérieur (33, 33') de reliefs (310, 310') dont au moins une paroi (313, 314, 313', 314') est inclinée.

2. Procédé selon la revendication précédente, dans lequel le dispositif forme un moule (30) pour impression nanométrique.

**3.** Procédé selon l'une quelconque des revendications précédentes, dans lequel fournir la structure comprend une étape de nanoimpression pour réaliser le réseau initial (32, 32') de reliefs (310, 310').

**4.** Procédé selon l'une quelconque des revendications 1 ou 2, dans lequel fournir la structure comprend une étape de lithographie optique ou électronique, pour réaliser le réseau initial (32, 32') de reliefs (310, 310').

**5.** Procédé selon l'une quelconque des revendications précédentes, dans lequel des paramètres du réseau initial (32, 32'), comprenant notamment une forme des reliefs (310, 310'), un pas P du réseau initial (32, 32') et un matériau du réseau initial (32, 32'), sont choisis de sorte à ce qu'après couchage des reliefs (310, 310'), chaque relief (310, 310') présente au moins une paroi (314, 314') inclinée d'un angle $\alpha$ différent de 90° par rapport à un plan z1x1 dans lequel s'étend principalement une face (35, 35') de la base (31, 31').

**6.** Procédé selon l'une quelconque des revendications précédentes, dans lequel les reliefs (310, 310') du réseau initial forment, avant l'étape de couchage, au moins l'un parmi :

- des lignes s'étendant principalement selon une direction z1 parallèle à un plan z1x1 dans lequel est principalement compris une face (35, 35') de la base (31, 31') de la structure depuis laquelle s'étendent les reliefs (310, 310') et
- des plots de section polygonale ou circulaire, la section étant prise selon le plan z1x1.

**7.** Procédé selon l'une quelconque des revendications précédentes, dans lequel coucher les reliefs (310, 310') comprend l'application d'au moins une force (F1, F2) de contact sur au moins l'un parmi la base (31, 31') de la structure et les reliefs (310, 310'), et l'application d'une force complémentaire ou d'une force de réaction (R) sur l'autre parmi la base (31, 31') de la structure et les reliefs (310, 310'), et de sorte à provoquer un déplacement relatif entre la base (31, 31') de la structure et les reliefs (310, 310').

**8.** Procédé selon la revendication précédente, dans lequel l'au moins une force (F1, F2) de contact de la structure présente :

- une composante (F1) sensiblement parallèle à un plan z1x1 dans lequel est principalement comprise une face (35, 35') de la base (31, 31') depuis laquelle s'étendent les reliefs (310, 310') ;
- une composante (F2) sensiblement perpendiculaire au plan z1x1.

**9.** Procédé selon l'une quelconque des deux revendications précédentes, dans lequel l'au moins une force (F1, F2) de contact est appliquée sur la base (31, 31') de la structure lorsque les extrémités distales (312, 312') des reliefs (310, 310') de la structure sont au contact d'un substrat intermédiaire (50), le substrat intermédiaire (50) présentant une face (53) destinée à entrer au contact des extrémités distales (312, 312') des reliefs (310, 310'), ladite face (53) comprenant de préférence un film (51) présentant un coefficient de friction inférieur ou égal à 0,01.

**10.** Procédé selon l'une quelconque des revendications 1 à 6, dans lequel coucher les reliefs (310,310') comprend appliquer un jet (5) de fluide sur les reliefs (310, 310') du réseau initial (32).

**11.** Procédé de réalisation d'au moins un réseau de motifs (210) inclinés sur une couche (200), le procédé comprenant au moins les étapes suivantes :

- fournir un moule (30) pour impression nanométrique en mettant en œuvre le procédé selon la revendication 2 ou selon l'une quelconque des revendications 3 à 6 prises dans leur combinaison avec la revendication 2:
- faire pénétrer le réseau ultérieur (33) de reliefs (310) inclinés dans la couche (200) pour former sur une première face (201) de la couche (200) un réseau de motifs (210) fonction des reliefs (310) inclinés,
- détacher le moule (30) de la couche (200).

**12.** Procédé selon la revendication précédente, dans lequel coucher les reliefs (310) de la structure initiale (32) du moule (30) comprend l'application d'au moins une force (F1, F2) de contact sur au moins l'un parmi la base (31) de la structure et les reliefs (310), et l'application d'une force complémentaire ou d'une force de réaction (R) sur l'autre parmi la base (31) de la structure et les reliefs (310) et de sorte à provoquer un déplacement relatif entre la base (31) de la structure et les reliefs (310) et dans lequel l'au moins une force (F1, F2) de contact de la structure présente :

- une composante (F1) sensiblement parallèle à un plan z1x1 dans lequel est principalement comprise une face (34) de la base (31) depuis laquelle s'étendent les des reliefs (310) ;
- une composante (F2) sensiblement perpendiculaire au plan z1x1.

13. Procédé selon la revendication 12, dans lequel l'au moins une force (F1, F2) de contact est appliquée sur la base (31) du moule (30) après pénétration d'une partie au moins du réseau initial (32) de reliefs (310) dans la couche (200), de préférence avant une pénétration complète des reliefs (310) du moule (30) dans la couche (200).

14. Procédé selon la revendication précédente, dans lequel :

- les reliefs (310) présentent, avant couchage, une hauteur H mesurée entre l'extrémité distale (312) des reliefs (310) et une face (34) de la base (32) du moule (30) depuis laquelle s'étendent les reliefs (310),
- l'au moins une force (F1, F2) de contact est appliquée sur la base (31) du moule (30) lorsque la hauteur hp des reliefs (310) ayant pénétrée dans la couche (200) est comprise entre 0.1 et 0.7 fois la hauteur H des reliefs (310).

15. Procédé selon l'une quelconque des revendications 11 à 14, dans lequel les reliefs (310) du moule (30) présentent un matériau de base et un revêtement recouvrant le matériau de base, le revêtement présentant un coefficient de friction inférieure à celui du matériau de base.

FIG. 1

FIG. 2A

FIG. 2B

FIG. 3A

FIG. 3B

FIG. 3C

FIG. 4A

FIG. 4B

FIG. 4C

FIG. 4D

40

42
41

FIG. 5A

1

37
36

40

FIG. 5B

3

37
36

40

FIG. 5C

37
31
32
30

42
41
40

FIG. 5D

FIG. 6A

FIG. 6B

FIG. 6C

FIG. 6D

FIG. 7

FIG. 8A

FIG. 8B

FIG. 9

FIG. 10

FIG. 11A

FIG. 11B

FIG. 11C

F3

31 — 30

310 —

201
200 } 101
202

100

FIG. 11D

30

200 } 101

100

FIG. 11E

210

200 } 101

100

FIG. 11F

FIG. 12A

FIG. 12B

FIG. 12C

30

200
100 } 101

FIG. 12D

211    210

200
100 } 101

FIG. 12E

FIG. 13B

FIG. 14B

FIG. 13A

FIG. 14A

FIG. 15A

FIG. 15B

FIG. 15C

FIG. 15D

FIG. 15E

FIG. 15F

FIG. 15G

FIG. 16

FIG. 17

FIG. 18A

FIG. 18B

Europäisches
Patentamt

European
Patent Office

Office européen
des brevets

**RAPPORT DE RECHERCHE EUROPEENNE**

Numéro de la demande

EP 20 20 8331

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 3 078 994 A1 (NOKIA TECHNOLOGIES OY [FI]) 12 octobre 2016 (2016-10-12) <br> * abrégé * <br> * paragraphes [0001], [0008], [0012]-[0014], [0013]-[0020], [0020]-[0026], [0027]-[0029], [0030], [0034], [0035]-[0046], [0052]-[0056], [0063]-[0065] * <br> * figures 1-7 * <br> ----- | 1-15 | INV. <br> G02B5/18 <br> G03F7/00 |
| X | JP H06 201907 A (OLYMPUS OPTICAL CO) 22 juillet 1994 (1994-07-22) <br> * abrégé * <br> * paragraphes [0001], [0010]-[0018] * <br> * figures 1-20 * <br> ----- | 1 | |
| X | US 2002/122255 A1 (OGUSU MAKOTO [JP] ET AL) 5 septembre 2002 (2002-09-05) <br> * abrégé * <br> * paragraphes [0001], [0022]-[0024], [0078]-[0080], [0109]-[0119] * <br> * figures 1-14 * <br> ----- | 1 | |

DOMAINES TECHNIQUES RECHERCHES (IPC)

G02B
G03F

Le présent rapport a été établi pour toutes les revendications

| Lieu de la recherche | Date d'achèvement de la recherche | Examinateur |
|---|---|---|
| Munich | 12 avril 2021 | Kienle, Philipp |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................
& : membre de la même famille, document correspondant

EPO FORM 1503 03.82 (P04C02)

**EP 3 822 670 A1**

**ANNEXE AU RAPPORT DE RECHERCHE EUROPEENNE
RELATIF A LA DEMANDE DE BREVET EUROPEEN NO.**

EP 20 20 8331

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-04-2021

| Document brevet cité au rapport de recherche | | Date de publication | Membre(s) de la famille de brevet(s) | | Date de publication |
|---|---|---|---|---|---|
| EP 3078994 | A1 | 12-10-2016 | EP | 3078994 A1 | 12-10-2016 |
| | | | EP | 3745167 A1 | 02-12-2020 |
| | | | US | 2018081170 A1 | 22-03-2018 |
| | | | US | 2020333590 A1 | 22-10-2020 |
| | | | WO | 2016162593 A1 | 13-10-2016 |
| JP H06201907 | A | 22-07-1994 | AUCUN | | |
| US 2002122255 | A1 | 05-09-2002 | JP | 2002189112 A | 05-07-2002 |
| | | | US | 2002122255 A1 | 05-09-2002 |

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **ARNE SCHLEUNITZ.** Fabrication of 3D patterns with vertical and sloped sidewalls by grayscale electron-beam lithography and thermal annealing. *Helmut Schift dans la revue Microelectronic Engineering,* 2011, vol. 88, 2736-2739